# EUROPÄISCHE PATENTANMELDUNG

(11) **EP 4 250 341 A1**
(43) Veröffentlichungstag der Anmeldung: **27.09.2023**
(21) Anmeldenummer: 22164084.0
(22) Anmeldetag: 24.03.2022
(51) Int. Cl.: H01L 21/67, H01L 21/677

(54) **VERFAHREN ZUM REINIGEN VON HALBLEITERSCHEIBEN IN EINER REINIGUNGSSTRASSE**

(71) Anmelder: Siltronic AG, 81677 München (DE)
(72) Erfinder: Möckel, Bertram, 09599 Freiberg (DE)
(74) Vertreter: Staudacher, Wolfgang

(57) **Zusammenfassung**

Verfahren zum Reinigen von Halbleiterscheiben in einer Reinigungsstrasse, die mindestens zwei Reinigungsmodule umfasst, in denen eine vertikal ausgerichtete Hableiterscheibe nacheinander während Reinigungsschritten mit einer Flüssigkeit des jeweiligen Reinigungsschritts behandelt wird, wobei mindestens ein Greifsystem, das zwei benachbarte Manipulatoren umfasst, über eines der Reinigungsmodule bewegt wird, und der eine Manipulator durch einen Schlitz einer Abdeckung des einen Reinigungsmoduls bewegt wird, um die Halbleiterscheibe abzulegen oder aufzunehmen, dadurch gekennzeichnet, dass der andere Manipulator zwischen dem Schlitz der Abdeckung des einen Reinigungsmoduls und einem Schlitz einer Abdeckung des anderen Reinigungsmoduls angeordnet ist.

## Beschreibung

Gegenstand der Erfindung ist ein Verfahren zum Reinigen von Halbleiterscheiben in einer Reinigungsstrasse, die mindestens zwei Reinigungsmodule umfasst, in denen eine vertikal ausgerichtete Hableiterscheibe nacheinander während Reinigungsschritten mit einer Flüssigkeit des jeweiligen Reinigungsschritts behandelt wird, wobei mindestens ein Greifsystem, das zwei benachbarte Manipulatoren umfasst, über eines der Reinigungsmodule bewegt wird, und der eine Manipulator durch einen Schlitz einer Abdeckung des einen Reinigungsmoduls bewegt wird, um die Halbleiterscheibe abzulegen oder aufzunehmen.

### Stand der Technik / Probleme

US2003 0 200 988 A1 beschreibt ein modulares Substrat-Reinigungssystem, mit dem mehrere Halbleiterscheiben gleichzeitig in einer Taktfolge nacheinander in Reinigungsmodulen einer Reinigungsstrasse einer Einzelscheiben-Reinigung unterzogen werden können.

Nachteilig daran ist dessen geringe Flexibilität.

In US2006 0 254 715 A1 ist ein Verfahren beschrieben, mit dem eine Halbleiterscheibe zwischen nacheinander angeordneten Reinigungsmodulen einer Reinigungsstrasse transportiert werden, um sie in jedem der Reinigungsmodule einer Einzelscheiben-Reinigung zu unterziehen. Im Zuge dessen wird mindestens einer von zwei Manipulatoren in das Reinigungsmodul abgesenkt, um die Halbleiterscheibe abzulegen oder aufzunehmen.

Nachteilig daran ist, dass Querkontaminationen vorkommen können, die den Erfolg des Reinigungsprozesses gefährden.

Aufgabe der vorliegenden Erfindung ist es, die Effizienz des Reinigens einer Halbleiterscheibe in einer Reinigungsstrasse zu steigern und zu vermeiden, dass die Halbleiterscheibe beim Handhaben im Zuge der Reinigung kontaminiert wird.

Die Aufgabe der Erfindung wird gelöst durch ein Verfahren zum Reinigen von Halbleiterscheiben in einer Reinigungsstrasse, die mindestens zwei Reinigungsmodule umfasst, in denen eine vertikal ausgerichtete Hableiterscheibe nacheinander während Reinigungsschritten mit einer Flüssigkeit des jeweiligen Reinigungsschritts behandelt wird, wobei mindestens ein Greifsystem, das zwei benachbarte Manipulatoren umfasst, über eines der Reinigungsmodule bewegt wird, und der eine Manipulator durch einen Schlitz einer Abdeckung des einen Reinigungsmoduls bewegt wird, um die Halbleiterscheibe abzulegen oder aufzunehmen, dadurch gekennzeichnet, dass der andere Manipulator zwischen dem Schlitz der Abdeckung des einen Reinigungsmoduls und einem Schlitz einer Abdeckung des anderen Reinigungsmoduls angeordnet ist.

Mit der Anordnung der Manipulatoren wird vermieden, dass beim Bewegen des einen Manipulators über ein Reinigungsmodul und dem Absenken dieses Manipulators in das Reinigungsmodul Flüssigkeit eine Querkontamination verursachen kann, wenn sie vom anderen Manipulator oder von einer Halbleiterscheibe, die vom anderen Manipulator gehalten wird, abtropft.

Die Reinigungsstrasse umfasst mindestens ein Greifsystem, an dem zwei Manipulatoren befestigt sind. Die beiden Manipulatoren sind in festem Abstand zueinander angeordnet. Vorzugsweise ist mindestens ein weiteres Greifsystem mit einem oder zwei Manipulatoren vorhanden. Ein weiteres Greifsystem mit einem Manipulator wird vorzugsweise eingesetzt, um eine Halbleiterscheibe nach dem letzten Reinigungsschritt zu einem Trockner zu transportieren.

Das Verfahren wird vorzugsweise verwendet, um eine Halbleiterscheibe nach einer Politur mittels CMP (chemical mechanical polishing) zu reinigen. Die Halbleiterscheibe durchläuft nach der CMP eine Sequenz von Reinigungsschritten. Während eines jeden der Reinigungsschritte wird die Halbleiterscheibe in einem Reinigungsmodul einer Einzelscheiben-Behandlung mit einem flüssigen Reinigungsmittel unterzogen. Die Halbleiterscheibe wird dabei vertikal stehend mit dem Reinigungsmittel behandelt. Gegebenenfalls steht sie auf Walzen und wird um ihr Zentrum gedreht. Die Reihenfolge der Sequenz kann mit der Reihenfolge der Anordnung der Reinigungsmodule übereinstimmen, muss aber nicht. Jedes Reinigungsmodul ist entweder zur Durchführung einer Badreinigung, einer Sprühreinigung, einer Bürstenreinigung oder einer Kombination von Sprühreinigung und Bürstenreinigung ausgestaltet. Bei der Badreinigung wird die Halbleiterscheibe ins Reinigungsmittel getaucht, bei der Sprühreinigung werden Vorder- und Rückseite der Halbleiterscheibe mit dem Reinigungsmittel besprüht und bei der Bürstenreinigung wird das Reinigungsmittel mittels sich drehender Bürsten auf der Vorder- und Rückseite der Halbleiterscheibe verteilt. Die Reinigungsflüssigkeit kann über die Walzen oder über separate Sprühdüsen zugeführt werden. Die Reinigung im Reinigungsbad kann durch Einstrahlen von Megaschall-Wellen unterstützt sein.

Jedes Reinigungsmodul der Reinigungsstrasse ist mit einer Abdeckung versehen, in der ein Schlitz eingearbeitet ist. Zum Ablegen einer Halbleiterscheibe in eines der Reinigungsmodule oder zum Herausnehmen einer Halbleiterscheibe aus einem der Reinigungsmodule wird einer von zwei Manipulatoren eines Greifsystems durch den Schlitz in dieses eine Reinigungsmodul bewegt. Um eine Querkontamination durch abtropfende Flüssigkeit zu vermeiden, bleibt der andere Manipulator des Greifsystems währenddessen in einer Position, die es Flüssigkeit, die vom anderen Manipulator oder einer von ihm gehaltenen Halbleiterscheibe abtropft, unmöglich macht durch den Schlitz der Abdeckung in dieses eine Reinigungsmodul zu fallen. Diese Position ist eine Anordnung des zweiten Manipulators zwischen dem Schlitz der Abdeckung dieses einen Reinigungsmoduls und dem Schlitz der Abdeckung eines benachbarten Reinigungsmoduls. Vorzugsweise ist der andere Manipulator über der Abdeckung dieses einen Reinigungsmoduls angeordnet, aber nicht über dem Schlitz der Abdeckung dieses einen Reinigungsmoduls.

Die nachfolgende Beschreibung nimmt auf eine Zeichnung Bezug. Die Darstellung beschränkt sich auf Merkmale, die für das Verständnis der Erfindung von Bedeutung sind.

### Kurzbeschreibung der Figuren

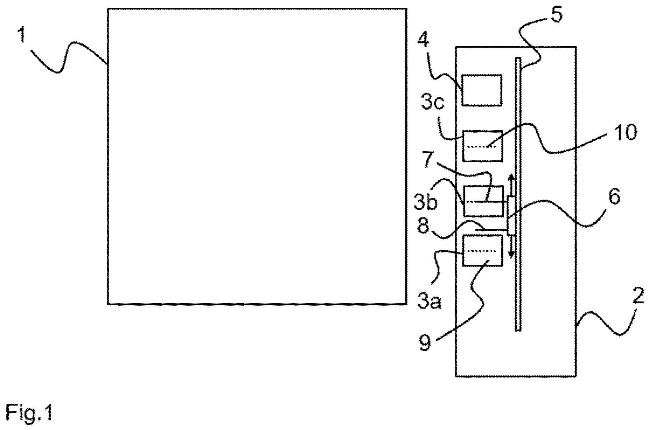

**Fig. 1** zeigt in Draufsicht eine Polierstation mit angeschlossener Reinigungsstation, die zur Durchführung des Verfahrens geeignet ist. Ihr Aufbau orientiert sich an der Vorrichtung, die in US2006 0 254 715 A1 dargestellt ist.

### Liste der verwendeten Bezugszeichen

- **1**: Polierstation
- **2**: Reinigungsstation
- **3a**: Reinigungsmodul
- **3b**: Reinigungsmodul
- **3c**: Reinigungsmodul
- **4**: Trockner
- **5**: Führung
- **6**: Greifsystem
- **7**: Manipulator
- **8**: Manipulator
- **9**: Abdeckung
- **10**: Schlitz

### Detaillierte Beschreibung eines erfindungsgemäßen Ausführungsbeispiels

Fig.1 zeigt schematisch die Anordnung einer Polierstation 1 und einer Reinigungsstation 2, die drei Reinigungsmodule 3a bis 3c umfasst. Diese Reinigungsmodule und ein Trockner 4 sind Bestandteil einer Reinigungsstrasse, in der eine Halbleiterscheibe nach abgeschlossener CMP in der Polierstation 1 gereinigt und getrocknet wird. Die Polierstation umfasst mindestens einen Polierkopf, der eine zu polierende Halbleiterscheibe während der Politur gegen ein Poliertuch presst (nicht dargestellt). Ebenfalls nicht dargestellt sind Roboter, die eine polierte Halbleiterscheibe von der Polierstation zur Reinigungsstation transportieren und Einrichtungen zum Zwischenlagern der Halbleiterscheibe.

Die Reinigungsstrasse umfasst eine Führung 5 für ein Greifsystem 6 mit zwei daran befestigten Manipulatoren 7 und 8. Eine zu reinigende Halbleiterscheibe wird von einem der beiden Manipulatoren 7, 8 gehalten und von einer Position über einem der Reinigungsmodule 3a bis 3c in das Reinigungsmodul abgesenkt und im Reinigungsmodul abgelegt. Eine in einem der Reinigungsmodule gereinigte Halbleiterscheibe wird von einem der beiden Manipulatoren 7, 8 im Reinigungsmodul aufgenommen und aus dem Reinigungsmodul gehoben. Vorzugsweise ist ein weiteres Greifsystem mit einem Manipulator vorhanden, der eine Halbleiterscheibe nach dem letzten Reinigungsschritt zum Trockner 4 transportiert (nicht dargestellt).

Jedes der Reinigungsmodule 3a bis 3c verfügt über eine Abdeckung 9 und jede dieser Abdeckungen über einen ein Schlitz 10, der den Manipulatoren 7 und 8 den Zugang zum jeweiligen Reinigungsmodul ermöglicht.

Falls einer der beiden Manipulatoren 7, 8 eine Halbleiterscheibe in einem Reinigungsmodul ablegt oder aus einem Reinigungsmodul heraushebt, nimmt der andere Manipulator eine Position zwischen dem Schlitz 10 der Abdeckung dieses Reinigungsmoduls und dem Schlitz 10 der Abdeckung eines benachbarten Reinigungsmoduls ein. In dieser Situation können Tropfen von Flüssigkeit, die gegebenenfalls vom anderen Manipulator oder einer Halbleiterscheibe, die vom anderen Manipulator gehalten wird, nicht durch den Schlitz der Abdeckung des Reinigungsmoduls fallen, in dem der eine Manipulator aktiv ist.

## Patentansprüche

1. Verfahren zum Reinigen von Halbleiterscheiben in einer Reinigungsstrasse, die mindestens zwei Reinigungsmodule umfasst, in denen eine vertikal ausgerichtete Hableiterscheibe nacheinander während Reinigungsschritten mit einer Flüssigkeit des jeweiligen Reinigungsschritts behandelt wird, wobei mindestens ein Greifsystem, das zwei benachbarte Manipulatoren umfasst, über eines der Reinigungsmodule bewegt wird, und der eine Manipulator durch einen Schlitz einer Abdeckung des einen Reinigungsmoduls bewegt wird, um die Halbleiterscheibe abzulegen oder aufzunehmen, **dadurch gekennzeichnet, dass** der andere Manipulator zwischen dem Schlitz der Abdeckung des einen Reinigungsmoduls und einem Schlitz einer Abdeckung des anderen Reinigungsmoduls angeordnet ist.

2. Verfahren nach Anspruch 1, **gekennzeichnet durch** drei Reinigungsmodule.

3. Verfahren nach Anspruch 1 oder Anspruch 2, **dadurch gekennzeichnet, dass** der andere Manipulator über der Abdeckung des einen Reinigungsmoduls angeordnet ist, aber nicht über dem Schlitz der Abdeckung des einen Reinigungsmoduls.
